# EUROPÄISCHE PATENTSCHRIFT

(11) **EP 2 342 764 B1**
(45) Veröffentlichungstag und Bekanntmachung des Hinweises auf die Patenterteilung: **13.01.2016**
(21) Anmeldenummer: 09765009.7
(22) Anmeldetag: 19.10.2009
(51) Int. Cl.: H01L 33/22, H01L 33/00, H01L 33/32

(54) **VERFAHREN ZUR HERSTELLUNG EINES STRAHLUNG EMITTIERENDEN DÜNNSCHICHTBAUELEMENTS UND STRAHLUNG EMITTIERENDES DÜNNSCHICHTBAUELEMENT**
METHOD FOR PRODUCING A RADIATION-EMITTING THIN-FILM COMPONENT AND RADIATION-EMITTING THIN-FILM COMPONENT
PROCÉDÉ DE FABRICATION D'UN COMPOSANT À COUCHE MINCE ÉMETTANT UN RAYONNEMENT ET COMPOSANT À COUCHE MINCE ÉMETTANT UN RAYONNEMENT

(30) Priorität: 06.11.2008 DE 102008056175
(43) Veröffentlichungstag der Anmeldung: 13.07.2011
(73) Patentinhaber: OSRAM Opto Semiconductors GmbH, 93055 Regensburg (DE)
(72) Erfinder: LUGAUER, Hans-Jürgen, 93161 Sinzing (DE); STREUBEL, Klaus, 93164 Laaber (DE); STRASSBURG, Martin, 93105 Tegernheim (DE); WINDISCH, Reiner, 93186 Pettendorf (DE); ENGL, Karl, 93080 Niedergebraching (DE)
(74) Vertreter: Epping - Hermann - Fischer
(86) Internationale Anmeldenummer: PCT/DE2009/001449
(87) Internationale Veröffentlichungsnummer: WO 2010/051790

(56) Entgegenhaltungen:
- EP-A- 1 422 748
- EP-A- 1 727 217
- EP-A- 1 796 180
- WO-A-2007/021069
- US-A1- 2007 093 037
- US-B1- 6 596 377
- KIKUCHI A ET AL: "INGAN/GAN MULTIPLE QUANTUM DISK NANOCOLUMN LIGHT-EMITTING DIODES GROWN ON (111) SI SUBSTRATE" JAPANESE JOURNAL OF APPLIED PHYSICS, JAPAN SOCIETY OF APPLIED PHYSICS, TOKYO,JP, Bd. 43, Nr. 12A, 1. Dezember 2004 (2004-12-01), Seiten L1524-L1526, XP001230716 ISSN: 0021-4922
- LIU XIANG ET AL: "Growth mechanism and properties of ZnO nanorods synthesized by plasma-enhanced chemical vapor deposition" JOURNAL OF APPLIED PHYSICS, AMERICAN INSTITUTE OF PHYSICS. NEW YORK, US, Bd. 95, Nr. 6, 15. März 2004 (2004-03-15), Seiten 3141-3147, XP012067613 ISSN: 0021-8979

## Beschreibung

Es wird ein Verfahren zur Herstellung eines Strahlung emittierenden Dünnschichtbauelements gemäß Anspruch 1 angegeben. Darüber hinaus wird ein Strahlung emittierendes Dünnschichtbauelement gemäß Anspruch 15 abgegeben.

Optoelektronische Bauteile wie etwa Leucht- oder Laserdioden haben eine breite technische Anwendung etwa im Bereich der Beleuchtung gefunden. Einige Gesichtspunkte, die der Verbreitung solcher Bauteile Vorschub leisten, sind deren hohe Effizienz und Widerstandsfähigkeit gegen äußere Belastungen sowie Umwelteinflüsse. Auch weisen optoelektronische Bauteile eine hohe Lebensdauer auf, die etwa zu einem reduzierten Wartungsaufwand für ein Leuchtmittel führt, das ein solches Bauteil aufweist. Die erzielbare Lebensdauer eines optoelektronischen Bauteils ist maßgeblich auch durch dessen Herstellungsprozess bestimmt.

In der Druckschrift EP 1 422 748 A1 sind ein III-Nitrid-Halbleiterfilm und eine Herstellungsmethode hierfür angegeben.

Die Druckschrift US 2007/0093037 A1 betrifft ein Halbleiterbauteil und ein Herstellungsverfahren hierfür.

Ein Dünnschichthalbleiterbauteil ist in der Druckschrift US 6,596,377 B1 offenbart.

Nanostrukturen zur Lichtauskopplung sind in der Druckschrift EP 1 727 217 A2 angegeben.

Eine zu lösende Aufgabe besteht darin, ein Verfahren zur Herstellung eines Strahlung emittierenden Dünnschichtbauelements mit einer hohen Lebensdauer anzugeben. Eine weitere zu lösende Aufgabe besteht darin, ein Strahlung emittierendes Dünnschichtbauelement mit einer hohen Lebensdauer anzugeben.

Gemäß dem Verfahren beinhaltet dieses den Schritt des Bereitstellens eines Substrats. Das Substrat weist bevorzugt eine ebene Substratoberseite auf. Beispielsweise ist das Substrat mit Silizium oder mit Saphir gestaltet. Ein Durchmesser des Substrats beträgt bevorzugt mindestens 10 cm, insbesondere mindestens 20 cm. Das Substrat kann als so genannter Wafer gestaltet sein.

Gemäß dem Verfahren beinhaltet dieses den Schritt des Aufwachsens von Nanostäben auf dem Substrat. Nanostäbe, englisch Nanorods, sind stab- oder säulenartige Strukturen, die einen Durchmesser im Nanometerbereich aufweisen. Der Durchmesser liegt insbesondere im Wertebereich zwischen 10 nm und 500 nm, bevorzugt zwischen 30 nm und 150 nm. Eine Höhe beziehungsweise Länge der Nanostäbe, in einer Richtung senkrecht zur Substratoberseite, beträgt einige 100 nm bis zu einigen Mikrometern. Die Nanostäbe können einen gleichmäßigen Durchmesser über deren gesamte Länge aufweisen oder auch Bereiche mit erniedrigtem oder erhöhtem Durchmesser. Die Nanostäbe können beispielsweise einen runden, hexagonalen oder polygonen Grundriss aufweisen. Das Aufwachsen der Nanostäbe auf dem Substrat erfolgt bevorzugt dergestalt, dass über weite Bereiche, also über mindestens 75 % der Fläche der Substratoberseite, oder über die gesamte Substratoberseite die Nanostäbe in einer gleichmäßigen Dichte und gleichmäßigen Ausgestaltung nach dem Aufwachsen vorhanden sind. Bevorzugt stehen die Nanostäbe in direktem Kontakt zum Substrat und werden direkt auf der Substratoberseite aufgewachsen.

Gemäß dem Verfahren umfasst dieses den Schritt des Aufbringens einer Halbleiterschichtenfolge. Die Halbleiterschichtenfolge weist mindestens eine aktive Schicht auf, die dazu ausgestaltet ist, im Betrieb des Dünnschichtbauelements elektromagnetische Strahlung zu emittieren. Die Halbleiterschichtenfolge basiert bevorzugt auf Gallium-Nitrid und/oder Gallium-Phosphid und/oder Gallium-Arsenid. "Basiert" bedeutet hierbei, dass wesentliche Materialkomponenten Gallium und Stickstoff, Phosphor beziehungsweise Arsen sind. Insbesondere kann die Halbleiterschichtenfolge auch weitere Materialien, wie Aluminium und Indium, aufweisen. Die Halbleiterschichtenfolge kann mehrere Schichten aufweisen, die sich in einer Materialzusammensetzung und/oder Dotierung unterscheiden können.

Gemäß zumindest einer Ausführungsform des Verfahrens beinhaltet das Aufbringen der Halbleiterschichtenfolge ein epitaktisches Aufwachsen. Die Halbleiterschichtenfolge kann zum Beispiel über Molekularstrahlepitaxie oder Gasphasenepitaxie aufgewachsen sein.

Gemäß dem Verfahren erfolgt das Aufwachsen der Halbleiterschichtenfolge auf den Nanostäben. Das heißt, die Halbleiterschichtenfolge wird auf derjenigen Seite der Nanostäbe aufgewachsen, die dem Substrat abgewandt ist. Die Halbleiterschichtenfolge steht bevorzugt in direktem Kontakt zu den Nanostäben.

Gemäß dem Verfahren umfasst dieses den Schritt des Aufbringens eines Trägers auf einer dem Substrat abgewandten Hauptseite der Halbleiterschichtenfolge. Der Träger kann beispielsweise über Bonden an der Halbleiterschichtenfolge befestigt werden. Der Träger wird beispielsweise nicht auf der Halbleiterschichtenfolge aufgewachsen, sondern separat gefertigt und anschließend auf die Halbleiterschichtenfolge aufgebracht und mit dieser mechanisch fest verbunden. Der Träger weist eine ausreichend hohe mechanische Stabilität auf, um die Halbleiterschichtenfolge zu tragen und vor Schäden zum Beispiel durch Verbiegen zu schützen.

Gemäß dem verfahren umfasst dieses den Schritt des Abtrennens von Halbleiterschichtenfolge und damit verbundenem Träger vom Substrat. Mit anderen Worten wird die am Träger befestigte Halbleiterschichtenfolge samt dem Träger vom Substrat separiert.

Gemäß dem Verfahren erfolgt das Abtrennen vom Substrat durch mindestens teilweises Zerstören der Nanostäbe. Durch das Zerstören der Nanostäbe wird also die mechanische Verbindung zwischen Halbleiterschichtenfolge und Träger einerseits und dem Substrat andererseits gelöst. Das Zerstören der Nanostäbe kann auf einem chemischen und/oder thermischen und/oder mechanischen Prozess basieren.

In mindestens einer Ausführungsform des Verfahrens zur Herstellung eines Strahlung emittierenden Dünnschichtbauelements weist dieses folgende Schritte auf:
- Bereitstellen eines Substrats,
- Aufwachsen von Nanostäben auf dem Substrat,
- epitaktisches Aufwachsen einer Halbleiterschichtenfolge mit mindestens einer aktiven Schicht auf den Nanostäben,
- Aufbringen eines Trägers auf der Halbleiterschichtenfolge, und
- Abtrennen von Halbleiterschichtenfolge und Träger vom Substrat durch mindestens teilweises Zerstören der Nanostäbe.

Durch ein solches Herstellungsverfahren können mechanische Verspannungen und Risse in der Halbleiterschichtenfolge, die durch das Aufwachsen resultieren, reduziert werden. Hierdurch erhöht sich die Lebensdauer eines über ein solches Verfahren hergestelltes Bauteils.

Eine Möglichkeit, optoelektronische Bauelemente herzustellen beziehungsweise aufzuwachsen, besteht in epitaktischen Verfahren. Eine Halbleiterschichtenfolge wird zum Beispiel aus der Gasphase auf einem Substrat abgeschieden beziehungsweise auf dem Substrat aufgewachsen. Zum Aufwachsen ist es erforderlich, dass die Gitterstruktur von Substrat und aufzuwachsendem Material zueinander passend gestaltet ist, insbesondere die Gitterkonstanten nicht zu stark voneinander abweichen. Ist dies nicht der Fall, so treten mechanische Verspannungen im aufgewachsenen Material der Halbleiterschichtenfolge auf. Insbesondere können diese Verspannungen beispielsweise zu einer Rissbildung in der Halbleiterschichtenfolge führen, die einen Einsatz der Halbleiterschichtenfolge für ein optoelektronisches Bauelement verhindern beziehungsweise die Lebensdauer eines solchen Bauelements deutlich reduzieren kann.

Zudem treten bei der Epitaxie vergleichsweise hohe Temperaturen von mehreren 100 Grad Celsius bis zu über 1000 Grad Celsius auf. Durch diese hohen Temperaturen und die insbesondere damit verbundenen Temperaturunterschiede, beispielsweise bedingt durch ein Abkühlen von Substrat und Halbleiterschichtenfolge nach dem epitaktischen Aufwachsen der Halbleiterschichtenfolge, können signifikante thermische Verspannungen entstehen, die beim Abkühlen zu einer Zerstörung oder Destabilisierung der Halbleiterschichtenfolge führen können. Somit sind Halbleiterschichtenfolge und Substrat bezüglich Gitterstruktur der Materialien und der thermischen Ausdehnungskoeffizienten bevorzugt aneinander anzupassen.

Im grünen, blauen oder im ultravioletten Spektralbereich emittierende Halbleiterchips basieren insbesondere auf GaN und/oder AlInGaN. Für solche Halbleitermaterialien sind Aufwachssubstrate, die eine geeignete Gitterstruktur und geeignete thermische Ausdehnungskoeffizienten aufweisen, nur schwer in ausreichender Qualität und Größe sowie Stückzahl verfügbar. Hierdurch erhöhen sich einerseits die Kosten für solche Halbleiterchips. Andererseits, wie beschrieben, kann sich aufgrund potentieller thermischer Verspannungen und Rissbildung die Lebensdauer eines auf einem solchen Substrat aufgewachsenen Halbleiterchips reduzieren.

Eine Möglichkeit, eine Anpassung von thermischen Ausdehnungskoeffizienten an Gitterstruktur von Substrat und Halbleiterschichtenfolge aneinander zu gewährleisten, ist die Verwendung von flächigen Pufferschichten. Solche Verfahren sind in der Druckschrift DE 100 56 645 A1 und in der Druckschrift DE 10 2004 038 573 A1 beschrieben. Auch in dem Artikel von Nakamura, Japanese Journal of Applied Physics, Vol. 30, No. 10A, Oktober 1991, Seiten L1705 bis L1707, ist ein derartiges Verfahren offenbart. Da in den angegebenen Dokumenten durchgehende Schichten beschrieben sind, treten zwar reduzierte, aber immer noch deutliche thermische Verspannungen und/oder Gitterfehlanpassungen auf. Hierdurch kann eine Ausbeute der Bauteile reduziert und eine Lebensdauer der Bauteile vermindert sein.

Einem hier beschriebenen Verfahren liegt unter anderem folgende Erkenntnis zugrunde: Nanostäbe weisen eine im Vergleich zum Durchmesser große Länge auf. Außerdem bedecken auf einem Substrat aufgebrachte Nanostäbe nur einen relativ geringen Anteil der Fläche. Das bedeutet, die Nanostäbe bilden eine mechanisch vergleichsweise flexibel gestaltete säulenartig aufgebaute Schicht. Da die Nanostäbe insbesondere nicht dicht gepackt vorliegen, können die Nanostäbe sich verbiegen und somit thermische Verspannungen aufgrund einer Gitterfehlanpassung auch über größere Flächen hinweg ausgleichen. Um auf den Nanostäben eine Halbleiterschichtenfolge insbesondere epitaktisch aufzuwachsen, weisen die Nanostäbe an einer dem Substrat abgewandten Seite bevorzugt eine Verbreiterung beziehungsweise Vergrößerung des Durchmessers auf, so dass sich zum Beispiel eine durchgehende Fläche ergibt. Ein Aufwachsen von Nanostäben auf einem Substrat ist in den Artikeln Kikuchi et al., Japanese Journal of Applied Physics, Vol. 43, No. 12A, 2004, Seiten L1524 bis L1526, und "Making ZnO nanorods the cool way", MaterialsToday, April 2005, Seite 13, und Liu et al., Journal of Applied Physics, Vol. 95, No. 6, Seiten 3141 bis 3147, beschrieben. Der Offenbarungsgehalt dieser Artikel bezüglich dem Aufwachsen der Nanostäbe wird hiermit durch Rückbezug mit aufgenommen.

Gemäß zumindest einer Ausführungsform des Verfahrens umfasst der Schritt des Aufwachsens der Nanostäbe das Ausbilden von Nukleationskeimen auf dem Substrat. Die Nanostäbe wachsen dann, von den Nukleationskeimen ausgehend, in einer Richtung senkrecht zur Substratoberseite weiter. Die Bildung der Nukleationskeime kann selbstorganisiert erfolgen. Das heißt, die Materialien von Substrat und Nanostäben weisen unterschiedliche Gitterkonstanten auf. Durch diese Gitterfehlanpassung entstehen Inseln des Materials der Nanostäbe auf der Substratoberseite, die die Nukleationskeime bilden. Alternativ oder zusätzlich können die Nukleationskeime nasschemisch erzeugt sein. Eine weitere Möglichkeit besteht darin, Nukleationskeime über einen photolithographischen Prozess mit Hilfe einer Maske oder über ein Nano-Imprint-Verfahren zu bilden. Weiterhin können die Nukleationskeime durch das Aufheizen einer Metallschicht, zum Beispiel mit Gold, gebildet werden. Durch das Aufheizen der Metallschicht bilden sich Inseln aus. Über das Ausbilden von Nukleationskeimen lassen sich die Nanostäbe effizient aufwachsen.

Gemäß zumindest einer Ausführungsform des Verfahrens erfolgt das zumindest teilweise Zerstören der Nanostäbe beim Abtrennen der Halbleiterschichtenfolge vom Substrat durch einen Prozess, der ein nass-chemischen Ätzen beinhaltet. Beispielsweise wird durch die Zwischenräume zwischen den Nanostäben eine ätzende Flüssigkeit geleitet. Diese ätzende Flüssigkeit löst die Nanostäbe, mindestens teilweise, auf. Hierdurch wird die mechanische Verbindung zwischen Substrat und Halbleiterschichtenfolge aufgelöst, so dass Halbleiterschichtenfolge und Träger effizient und ohne mechanische Belastungen der Halbleiterschichtenfolge voneinander separierbar sind.

Gemäß dem Verfahren weisen die Nanostäbe Oberteile auf, die sich an vom Substrat abgewandten Bereiche der Nanostäbe befinden und kegel- oder pyramidenartig gestaltet sind. Zudem weisen die Nanostäbe an einem Unterteil, der dem Substrat zugewandt ist, eine zum Beispiel zylinder- oder prismenartige Gestalt auf. Eine spitzenartige Struktur der kegel- oder pyramidenartigen Oberteile weist hierbei in Richtung zum Substrat und bildet einen Übergangsbereich zwischen Oberteilen und Unterteilen.

Die Oberteile der Nanostäbe verjüngen sich also in Richtung zum Substrat hin. Mit anderen Worten sind die Nanostäbe trichterartig gestaltet, und eine Spitze des Trichters weist zum Substrat. Derart gestaltete Nanostäbe ermöglichen ein effizientes Aufwachsen der Halbleiterschichtenfolge und gleichzeitig eine hohe dämpfende Wirkung der Nanostäbe gegenüber auftretenden thermischen und/oder strukturell bedingten Verspannungen beim Aufwachsen der Halbleiterschichtenfolge.

Gemäß dem Verfahren werden die Nanostäbe frei von einer aktiven Zone gewachsen. Das heißt, die Nanostäbe weisen keinen Bereich auf, der dazu gestaltet ist, elektromagnetische Strahlung zu emittieren, zu empfangen oder zu konvertieren. Die Nanostäbe bilden in diesem Sinne kein funktionelles Element des Strahlung emittierenden Dünnschichtbauelements, das mit einem solchen Verfahren hergestellt wird. Sind die Nanostäbe frei von einer aktiven Zone, so erfolgt das Aufwachsen der Nanostäbe auf dem Substrat mit geringem Aufwand. Hierdurch ist ein großflächiges Aufwachsen der Nanostäbe auf dem Substrat ermöglicht.

Gemäß zumindest einer Ausführungsform des Verfahrens sind die Nanostäbe in einem regelmäßigen Gitter angeordnet. Das bedeutet, der überwiegende Anteil der Nanostäbe, insbesondere mehr als 80 Prozent, befindet sich an Gitterpunkten des Gitters. Das Gitter ist etwa hexagonal, quadratisch oder rautenförmig gestaltet. Sind die Nanostäbe in einem regelmäßigen Gitter angeordnet, so bilden die Nanostäbe für die Halbleiterschichtenfolge eine Aufwachsfläche einer hohen Qualität.

Gemäß zumindest einer Ausführungsform des Verfahrens beträgt ein mittlerer Gitterabstand des Gitters höchstens 1000 nm, bevorzugt höchstens 400 nm. Der mittlere Gitterabstand ist also insbesondere kleiner als eine Wellenlänge einer von der aktiven Schicht im Betrieb des Dünnschichtbauelements zu emittierenden elektromagnetischen Strahlung. Hierdurch lassen sich die optischen Eigenschaften des Dünnschichtbauelements gezielt beeinflussen.

Gemäß zumindest einer Ausführungsform des Verfahrens beträgt ein mittlerer Durchmesser der Nanostäbe höchstens eine halbe Wellenlänge, bevorzugt höchstens eine viertel Wellenlänge der von der aktiven Schicht im Betrieb emittierten höchstfrequenten Strahlung. Unter dem mittleren Durchmesser der Nanostäbe ist der über die gesamte Länge der Nanostäbe gemittelte Durchmesser zu verstehen. Weisen die Nanostäbe beispielsweise ein zylinderartiges Unterteil und ein kegelartiges Oberteil auf, so ist über Oberteil und Unterteil bezüglich des Durchmessers zu mitteln. Emittiert die mindestens eine aktive Schicht der Halbleiterschichtenfolge beispielsweise Strahlung im blauen Spektralbereich, und beträgt eine kleinste, von der aktiven Schicht emittierte Wellenlänge 430 nm, so ist der mittlere Durchmesser kleiner als 215 nm, bevorzugt kleiner als 107 nm. Bevorzugt sind, im Rahmen der Herstellungstoleranzen, mindestens die Hälfte, insbesondere mindestens 75 % der Nanostäbe mit einem solchen mittleren Durchmesser gestaltet. Durch derartige Nanostäbe lassen sich die optischen Eigenschaften des Dünnschichtbauelements gezielt einstellen.

Gemäß zumindest einer Ausführungsform des Verfahrens beträgt eine Länge der Nanostäbe in einer Richtung senkrecht zur Substratoberseite mindestens 500 nm. Durch eine solche Länge der Nanostäbe ist gewährleistet, dass diese eine ausreichend hohe Flexibilität aufweisen, um mechanisch und/oder strukturell bedingte Verspannungen aufgrund einer Gitterfehlanpassung zwischen Substrat und Halbleiterschichtenfolge ausgleichen zu können.

Gemäß dem Verfahren sind Halbleiterschichtenfolge und Nanostäbe mit einem unterschiedlichen Material gestaltet.

Zum Beispiel basieren oder bestehen die Nanostäbe aus ZnO und/oder GaN, und die Halbleiterschichtenfolge besteht aus oder basiert auf InGaN, InAlGaN und/oder AlGaN. Mit anderen Worten kann ein Al-Gehalt und/oder ein In-Gehalt der Nanostäbe um mindestens einen Faktor 10 geringer sein als bei der Halbleiterschichtenfolge. Gemäß zumindest einer Ausführungsform des Verfahrens sind Nanostäbe und Substrat mit verschiedenen Materialien gestaltet. Hierdurch erhöhen sich die Ausgestaltungsmöglichkeiten des Dünnschichtbauelements. Zudem kann die Struktur der Nanostäbe, je nach den konkreten Anforderungen, gezielt eingestellt werden.

Gemäß zumindest einer Ausführungsform des Verfahrens sind Nanostäbe und Halbleiterschichtenfolge auf dem selben Materialsystem basierend gestaltet. Insbesondere basieren sowohl Nanostäbe als auch Halbleiterschichtenfolge auf GaN, AlGaN, InGaN oder AlInGaN, so dass Dünnschichtbauelemente mit einer Emission im blauen Spektralbereich realisierbar sind. Durch solche Nanostäbe ist gewährleistet, dass beim Aufwachsen der Halbleiterschichtenfolge auf den Nanostäben besonders geringe mechanische Verspannungen aufgrund einer Gitterfehlanpassung auftreten.

Gemäß zumindest einer Ausführungsform des Verfahrens verbleiben beim Abtrennen von der Halbleiterschichtenfolge vom Substrat die Oberteile der Nanostäbe mindestens teilweise an der Halbleiterschichtenfolge. Hierdurch kann durch die kegel- oder pyramidenartig gestalteten Oberteile eine Lichtauskoppelstruktur an der Halbleiterschichtenfolge gestaltet werden.

Gemäß zumindest einer Ausführungsform des Verfahrens werden die Oberteile der Nanostäbe, die beispielsweise beim Abtrennen an der Halbleiterschichtenfolge verbleiben, nachfolgend entfernt. Dies kann über Polieren erfolgen. Hierdurch lassen sich Dünnschichtbauelemente realisieren, die an einem weiteren, externen Träger effizient angebracht werden können.

Gemäß zumindest einer Ausführungsform des Verfahrens sind die Nanostäbe mit einem amorphen oder polykristallinen Material gebildet. Das heißt, die Nanostäbe bestehen nicht aus einem Einkristall. Hierdurch erhöhen sich die Gestaltungsmöglichkeiten der Nanostäbe bezüglich Materialauswahl und Prozessparametern beim Aufwachsen der Nanostäbe. Auch die elektrischen Eigenschaften der Nanostäbe, wie deren Leitfähigkeit, lassen sich hierüber beeinflussen.

Gemäß zumindest einer Ausführungsform des Verfahrens wird durch die Nanostäbe mindestens ein photonischer Kristall gebildet. Unter einem photonischen Kristall wird eine periodische Struktur verstanden, die dazu geeignet ist, über Beugung und/oder Interferenz die optischen Eigenschaften der vom Dünnschichtbauelement emittierten Strahlung zu beeinflussen. Beispielsweise können die Nanostäbe beziehungsweise die Oberteile der Nanostäbe auf der Halbleiterschichtenfolge verbleiben. Durch den Gitterabstand der Nanostäbe lässt sich dann etwa ein Interferenzfilter realisieren, so dass Strahlung einer vorgegebenen Wellenlänge beispielsweise nur in bestimmten Winkelbereichen das Dünnschichtbauelement nachfolgend verlassen kann. Durch eine Ausgestaltung der Nanostäbe als photonischer Kristall erhöhen sich die Einsatzmöglichkeiten des Dünnschichtbauelements.

Gemäß zumindest einer Ausführungsform des Verfahrens wird die Halbleiterschichtenfolge mit einer Dicke von höchstens 100 µm, insbesondere von höchstens 50 µm, bevorzugt von höchstens 20 µm aufgewachsen. Hierdurch lassen sich besonders dünne Dünnschichtbauelemente realisieren.

Gemäß zumindest einer Ausführungsform des Verfahrens weist das damit hergestellte Dünnschichtbauelement eine Dicke von höchstens 500 µm, bevorzugt von höchstens 170 µm, besonders bevorzugt von höchstens 75 µm, insbesondere von höchstens 40 µm auf. Alternativ oder zusätzlich ist der Quotient aus einer mittleren lateralen Ausdehnung und einer Dicke des Dünnschichtbauelements größer oder gleich 5, bevorzugt größer oder gleich 10, insbesondere größer oder gleich 20.

Gemäß zumindest einer Ausführungsform des Verfahrens weist die insbesondere epitaktisch aufgewachsene Halbleiterschichtenfolge des mit dem Verfahren hergestellten Dünnschichtbauelements eine Dicke von höchstens 20 µm, bevorzugt von höchstens 8 µm auf.

Gemäß dem Verfahren bilden die Nanostäbe an einer dem Substrat abgewandten Seite der Oberteile eine geschlossene Schicht. Hierdurch ist ein Aufwachsen der Halbleiterschichtenfolge auf den Nanostäben erleichtert.

Gemäß zumindest einer Ausführungsform des Verfahrens ist eine Länge der Oberteile der Nanostäbe, in einer Richtung senkrecht zur Substratoberseite, kleiner als eine Länge der Unterteile der Nanostäbe. Die Unterteile können eine Länge aufweisen, die kleiner ist als ein Viertel der Länge der Oberteile. Ebenso können die Nanostäbe ausschließlich kegel- oder pyramidenartige Oberteile aufweisen. Durch eine solche Ausgestaltung der Nanostäbe verkürzt sich die für das Wachsen der Nanostäbe erforderliche Zeit.

Gemäß zumindest einer Ausführungsform des Verfahrens weisen die Nanostäbe eine Länge im Bereich zwischen 500 nm und 1,5 µm auf. Hierdurch weisen die Nanostäbe eine ausreichende Flexibilität und gleichzeitig eine ausreichende Festigkeit auf, um als Wachstumsgrundlage für die Halbleiterschichtenfolge eingesetzt werden zu können.

Gemäß zumindest einer Ausführungsform des Verfahrens wird das Substrat beim Abtrennen von Halbleiterschichtenfolge und Träger nicht beschädigt. Das heißt, das Abtrennen erfolgt für das Substrat zerstörungsfrei. Hierdurch ist es ermöglicht, dass das Substrat mehrfach zum Aufwachsen einer Halbleiterschichtenfolge verwendet werden kann. Hierdurch reduzieren sich die Kosten für das Verfahren.

Gemäß zumindest einer Ausführungsform des Verfahrens basieren die Nanostäbe auf ZnO oder auf GaN. Solche Nanostäbe lassen sich effizient herstellen und die Ausgestaltung der Nanostäbe kann über die Prozessparameter beim Aufwachsen über einen weiten Bereich gezielt eingestellt werden.

Gemäß zumindest einer Ausführungsform des Verfahrens ist das Substrat mit Silizium gestaltet und die Nanostäbe selbstorganisierend aufgebracht. Nanostäbe und Halbleiterschichtenfolge basieren auf Gallium-Nitrid und die Nanostäbe weisen eine Länge im Bereich zwischen 500 nm und 1,5 µm und einen Durchmesser im Bereich zwischen 30 nm und 150 nm auf. Die Nanostäbe sind frei von einer aktiven Zone. Das Abtrennen der Halbleiterschichtenfolge vom Substrat erfolgt nass-chemisch und das Substrat wird hierdurch nicht beschädigt. Durch ein solches Verfahren hergestellte Dünnschichtbauelemente weisen eine hohe Lebensdauer auf.

Gemäß zumindest einer Ausführungsform des Verfahrens, bei dem das Substrat mit Saphir oder Silizium gebildet ist, sind die Nanostäbe mit ZnO oder GaN gestaltet und über einen selbstorganisierenden Prozess aufgewachsen. Ebenso ist es möglich, dass die Nanostäbe über einen photolithographischen Verfahrensschritt aufgebracht werden. Die Halbleiterschichtenfolge weist eine Dicke von höchstens 100 µm, bevorzugt von höchstens 20 µm auf und basiert auf Gallium-Nitrid. Die Oberteile der Nanostäbe werden kegel- oder pyramidenförmig gewachsen, wobei die Oberteile eine spitzenartige Struktur aufweisen, wobei diese spitzenartige Struktur in Richtung zum Substrat weist. Weiterhin verbleibt nach dem Abtrennen der Halbleiterschichtenfolge vom Substrat zumindest ein Teil der Oberteile der Nanostäbe an der Halbleiterschichtenfolge. Hierdurch wird eine Lichtauskoppelstruktur gebildet. Ein über ein solches Verfahren hergestelltes Dünnschichtbauelement weist eine hohe Lichtauskoppeleffizienz auf.

Gemäß zumindest einer Ausführungsform des Verfahrens erfolgen die Schritte Aufwachsen von Nanostäben und Halbleiterschichtenfolgen, Aufbringen des Trägers und Ablösen vom Substrat im Wafer-Verbund. Beispielsweise eine Separierung in einzelne Dünnschichtbauelemente erfolgt erst nach dem Abtrennen vom Substrat. Durch ein solches Verfahren wird die Handhabung der Halbleiterschichtenfolge und dem Träger vereinfacht. Hierdurch senken sich die mechanischen Belastungen für die Halbleiterschichtenfolge im Rahmen der Herstellung.

Es wird darüber hinaus ein Strahlung emittierendes Dünnschichtbauelement gemäß Anspruch 15 angegeben. Beispielsweise kann das Dünnschichtbauelement mittels einer oder mehrerer der oben genannten Ausführungsformen eines Verfahrens hergestellt sein. Merkmale des Verfahrens sind daher auch für das Dünnschichtbauelement offenbart und umgekehrt.

Das Dünnschichtbauelement umfasst einen Träger. Weiterhin umfasst das Dünnschichtbauelement eine Halbleiterschichtenfolge mit mindestens einer aktiven Schicht, die dazu gestaltet ist, elektromagnetische Strahlung im Betrieb des Dünnschichtbauelements zu emittieren. Die Halbleiterschichtenfolge ist auf dem Träger aufgebracht. Zudem weist das Dünnschichtbauelement eine Lichtauskoppelstruktur auf, die mit Nanostäben gebildet ist und sich an einer dem Träger abgewandten Hauptseite der Halbleiterschichtenfolge befindet. Der Träger ist hierbei kein Wachstumssubstrat für die Halbleiterschichtenfolge, sondern nachträglich nach dem Wachsen der Halbleiterschichtenfolge auf dieser aufgebracht. Weiterhin sind die die Lichtauskoppelstruktur bildenden Nanostäbe kegel- oder pyramidenartig gestaltet, wobei spitzenartige Strukturen der Nanostäbe von der Halbleiterschichtenfolge weg weisen, und an einer dem Träger abgewandten Hauptseite der Halbleiterschichtenfolge durch die Nanostäbe eine geschlossene Schicht gebildet ist.

Gemäß zumindest einer Ausführungsform des Dünnschichtbauelements ist dieses als Leuchtdiode gestaltet. Hierdurch kann das Dünnschichtbauelement vielfältig eingesetzt werden.

Einige Anwendungsbereiche, in denen ein hier beschriebenes Dünnschichtbauelement Verwendung finden kann, sind etwa die Hinterleuchtung von Displays oder Anzeigeeinrichtungen. Weiterhin kann ein hier beschriebenes Dünnschichtbauelement etwa in Beleuchtungseinrichtungen zu Projektionszwecken, in Scheinwerfern oder Lichtstrahlern oder bei der Allgemeinbeleuchtung eingesetzt werden.

Nachfolgend wird ein hier beschriebenes Verfahren sowie ein hier beschriebenes Dünnschichtbauelement unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Darstellung verschiedener Verfahrensschritte der Herstellung eines hier beschriebenen Dünnschichtbauelements,
- Figur 2: eine schematische Darstellung eines Ausführungsbeispiels hier beschriebener Nanostäbe, und
- Figur 3: schematische Draufsichten von Ausführungsbeispielen von hier beschriebenen Nanostäben.

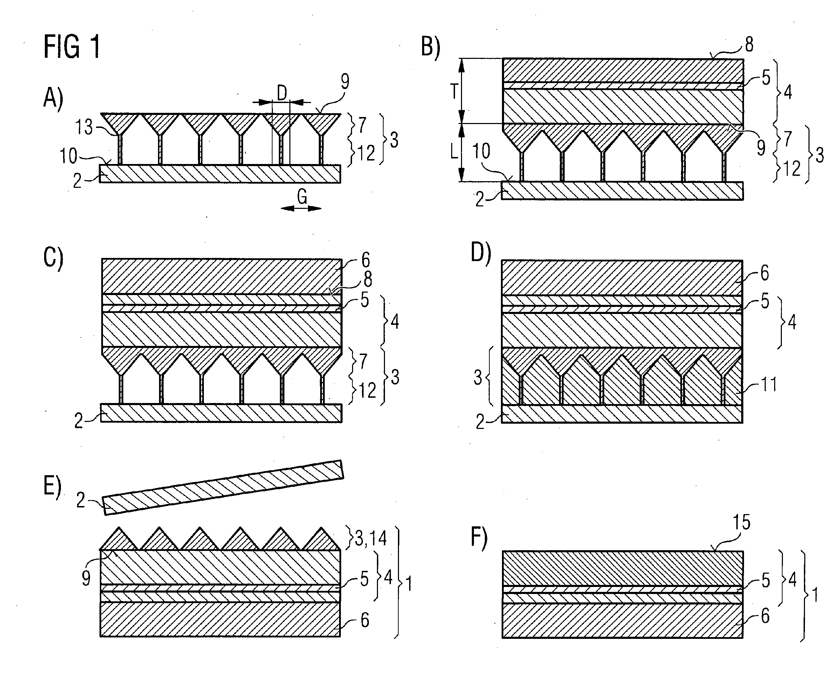

In Figur 1 ist eine Ausführungsform eines Verfahrens zur Herstellung eines Dünnschichtbauelements 1 illustriert.

Figur 1A zeigt auf einer Substratoberseite 10 eines Substrats 2 aufgewachsene Nanostäbe 3. Das Substrat 2 ist ein Siliziumwafer. Durch die Nanostäbe 3 ist das Substrat 2 großflächig bedeckt. Die Nanostäbe 3 weisen jeweils ein Unterteil 12 und ein Oberteil 7 auf. Das Unterteil 12 ist zylinder- und/oder säulenartig gestaltet. Das Oberteil 7 umfasst eine spitzenartige Struktur 13, die den Übergang zwischen Unterteil 12 und Oberteil 7 bildet. Die spitzenartige Struktur 13 weist in Richtung Substrat 2. Die Oberteile 7 sind kegel- oder pyramidenartig gestaltet. An einer dem Substrat 2 abgewandten Seite der Oberteile 7 ist eine geschlossene Schicht 9 mit einem Material der Nanostäbe 3 gebildet. Die Nanostäbe 3 sind über einen selbstorganisierten Prozess auf dem Substrat 2 aufgewachsen.

Ein mittlerer Gitterabstand G zwischen den Nanostäben beträgt zirka 300 nm. Ein mittlerer Durchmesser D beträgt zirka 100 nm. Der mittlere Durchmesser D bezieht sich auf eine gesamte Länge L der Nanostäbe 3 in einer Richtung senkrecht zur Substratoberseite 10. Für den mittleren Durchmesser D sind also die Unterteile 12 und die Oberteile 7 zu berücksichtigen. Die Länge L der Nanostäbe 3 beträgt ca. 1 µm.

Das Aufbringen einer Halbleiterschichtenfolge 4 auf die geschlossene Schicht 9 ist in Figur 1B dargestellt. Die Halbleiterschichtenfolge 4 wird epitaktisch auf die geschlossene Schicht 9 aufgewachsen. Die Halbleiterschichtenfolge 4 umfasst eine aktive Schicht 5, die dazu gestaltet ist, im Betrieb des Dünnschichtbauelements 1 elektromagnetische Strahlung zu emittieren. Die Halbleiterschichtenfolge 4 basiert, wie auch die Nanostäbe 3, auf GaN. Die Halbleiterschichtenfolge 4 weist eine dem Substrat 2 abgewandte Hauptseite 8 auf. Eine Dicke T der Halbleiterschichtenfolge 4 beträgt zirka 12 µm.

In einem nachfolgenden Verfahrensschritt, siehe Figur 1C, wird auf die Hauptseite 8 der Halbleiterschichtenfolge 4 ein Träger 6 aufgebracht. Der Träger 6 wird an der Halbleiterschichtenfolge 4 beispielsweise über Bonden befestigt. Alternativ kann der Träger 6 auf der Halbleiterschichtenfolge 4 aufgeklebt oder, etwa über eine auf der Halbleiterschichtenfolge 4 und auf dem Träger 6 aufgebrachten nicht gezeichneten Au:Sn-Legierung, aufgelötet werden. Optional ist es möglich, dass zwischen dem Träger 6 und der Halbleiterschichtenfolge 4 eine nicht gezeichnete Zwischenschicht aufgebracht wird, die zum Beispiel reflektierend gestaltet ist.

Der Träger 6 kann aus dem gleichen Material wie das Substrat 2 bestehen. Bevorzugt ist der Träger 6 elektrisch leitend. Zum Beispiel weist der Träger 6 Silizium, Germanium oder ein Metall auf. Ebenso ist es möglich, dass der Träger 6 eine Keramik wie Al₂O₃ umfasst, wobei auf der Keramik elektrisch leitfähige Strukturen aufgebracht sein können.

In Figur 1D ist gezeigt, dass Halbleiterschichtenfolge 4 und Träger 6 vom Substrat 2 über einen nass-chemischen Prozess separiert werden. Ein flüssiges Ätzmittel 11 wird zwischen Substrat 2 und Halbleiterschichtenfolge 4 im Bereich der Nanostäben 3 verwendet. Das Ätzmittel 11 trägt das Material, mit dem die Nanostäbe 3 gestaltet sind, teilweise ab. Hierdurch werden insbesondere die Unterteile 12 der Nanostäbe 3 aufgelöst beziehungsweise zerstört. Durch dieses Zerstören der Unterteile 12 löst sich die mit dem Träger 6 verbundene Halbleiterschichtenfolge 4 vom Substrat 2. Dies ist in Figur 1E zu sehen. Beim Ablösen ist also kein Laser-Abhebeverfahren, englisch Laser Lift Off, erforderlich.

Optional können, siehe Figur 1F, beispielsweise über Polieren die an der Halbleiterschichtenfolge 4 verbleibenden Oberteile 7 der Nanostäbe 3 abgetragen werden. Hierdurch resultiert ein Dünnschichtbauelement 1, beispielsweise in Form einer Leuchtdiode, mit einer dem Träger 6 abgewandten ebenen Lichtdurchtrittsfläche 15 der Halbleiterschichtenfolge 4.

Ein Ausführungsbeispiel einer bevorzugten Ausführungsform des Dünnschichtbauelements 1 ist in Figur 1E gezeigt. Durch die Oberteile 7 der Nanostäbe 3 ist eine Lichtauskoppelstruktur 14 gebildet. Die Periodizität der Lichtauskoppelstruktur 14 entspricht dem Gitterabstand G der Nanostäbe 3, siehe Figur 1A. Der Gitterabstand G ist kleiner als eine Wellenlänge einer von der aktiven Schicht 5 im Betrieb des Dünnschichtbauelements 1 erzeugten Strahlung. Die geschlossene Schicht 9 verbleibt an der dem Träger 6 abgewandten Seite der Halbleiterschichtenfolge 4.

Die Lichtauskoppelstruktur 14 wird also beim Abtrennen von Halbleiterschichtenfolge 4 und Träger 6 vom Substrat 2 erzeugt. Eine weitere Möglichkeit, eine Aufrauung für eine verbesserte Lichtauskopplung zu erzielen, besteht durch einen mechanischen Prozess. Allerdings sind hierdurch nur unregelmäßige Strukturen erzielbar, deren genaue Abmessungen nur schwer zu kontrollieren sind. Insbesondere die Flankenwinkel einer solchen Aufrauung können eine große Streuung aufweisen und somit die Lichtauskoppeleffizienz beeinträchtigen. Auch durch nass-chemisches Ätzen unter Ausnutzung von Rauhigkeiten aufgrund von Kristalldefekten oder Störungen der Kristalloberfläche der Halbleiterschichtenfolge 4 erzeugte Aufrauungen lassen sich nur bedingt reproduzierbar herstellen. Zudem wird durch ein nass-chemisches Aufrauen der Halbleiterschichtenfolge 4 eine erhebliche Menge an Material, mehr als die Tiefe der Aufrauung, abgetragen, um eine für eine hohe Lichtauskopplung ausreichende Aufrauung zu erzielen. Hierdurch sind höhere Schichtdicken der Halbleiterschichtenfolge 4 zu fertigen, was in einer verstärkten Rissbildung und somit reduzierten Lebensdauer beziehungsweise Ausbeute der Bauteile resultieren kann. Beim hier beschriebenen Verfahren muss im Gegensatz dazu nur eine geringe Materialmenge, die im Wesentlichen durch die Unterteile 12 der Nanostäbe 3 gebildet wird, nass-chemisch entfernt werden. Die Oberteile 7 der Nanostäbe 3 bleiben bezüglich ihrer Struktur vom Ätzmittel 11 weitgehend unbeeinflusst.

Es ist auch möglich, eine Aufrauung zur Steigerung der Lichtauskopplung über photolithographische Prozesse zu erzielen. Allerdings ist hierdurch nicht die gesamte Fläche zugänglich, da mit Photolack bedeckte Bereiche nicht aufgeraut werden können. Es verbleiben also an der Lichtdurchtrittsfläche 15 bei einem solchen Prozess Bereiche, die zur Hauptseite 9 der Halbleiterschichtenfolge 4 parallel ausgerichtet sind. In solchen Bereichen ist die Lichtauskoppeleffizienz vermindert. Durch ein hier beschriebenes Verfahren kann dies umgangen werden, die gesamte, dem Träger 6 abgewandte Fläche der Halbleiterschichtenfolge 4 kann mit der Lichtauskoppelstruktur 14 versehen werden.

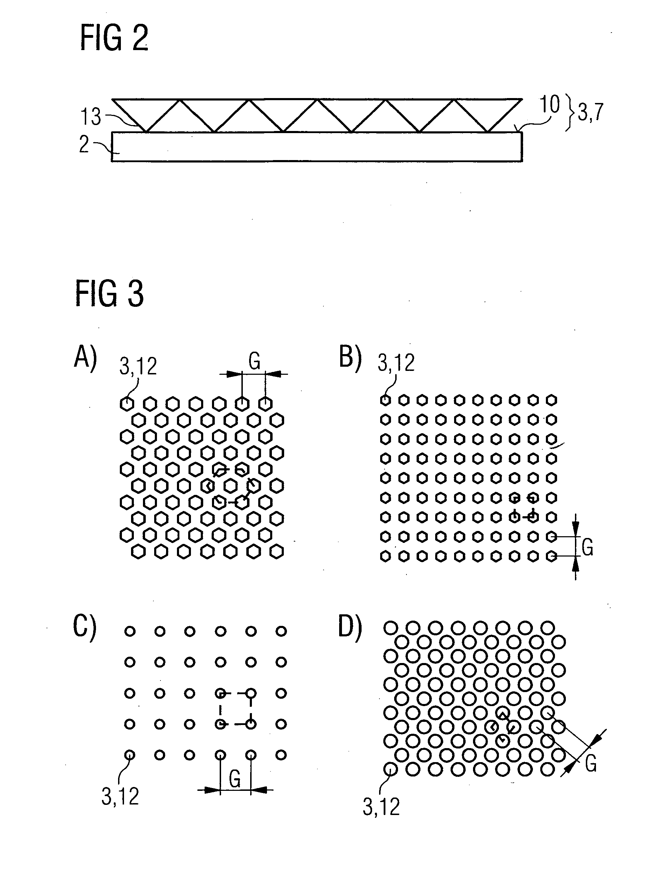

In Figur 2 ist eine weitere Ausgestaltungsmöglichkeit der Nanostäbe 3 dargestellt. Das Unterteil 12 der Nanostäbe 3 ist hierbei nicht mehr vorhanden. Die Oberteile 7 sitzen also mit der spitzenartigen Struktur 13 auf dem Substrat 2 auf und bilden die Nanostäbe 3 ausschließlich. Die Nanostäbe 3 sind mit ZnO oder GaN gestaltet.

In Figur 3 ist eine schematische Draufsicht auf die Nanostäbe 3 dargestellt. Aus Gründen der graphischen Darstellung ist ein Schnitt durch die Nanostäbe im Bereich der Unterteile 12 gezeichnet, so dass die Oberteile 7 die Unterteile 12 nicht überdecken. Die gezeigten Draufsichten können beispielsweise beim Ausführungsbeispiel gemäß Figur 1 realisiert sein.

Gemäß Figur 3A weisen die Nanostäbe 3 einen hexagonalen Grundriss auf. Die Nanostäbe 3 sind zudem in einem hexagonalen Gitter, symbolisiert durch eine Strichlinie, angeordnet, das einen mittleren Gitterabstand G von zirka 300 nm aufweist.

Gemäß Figur 3B und Figur 3C weisen die Nanostäbe 3 eine quadratische Gitterstruktur auf, symbolisiert durch Strichlinien. Gemäß Figur 3C bedecken die Unterteile 12 der Nanostäbe 3 nur einen geringeren Anteil der Substratoberseite 10. Bedingt hierdurch ist der mittlere Gitterabstand G in Figur 3C größer als in Figur 3B.

Beim Ausführungsbeispiel gemäß Figur 3D weisen die Nanostäbe 3, wie auch gemäß Figur 3C, einen kreisförmigen Grundriss auf. Die Nanostäbe 3 sind in einem rautenartigen Gitter angeordnet.

Optional können Teile der Unterteile 12 beim Abtrennen der Halbleiterschichtenfolge 4 vom Substrat 2 an der Halbleiterschichtenfolge 4 beziehungsweise an den Oberteilen 7 verbleiben. Der mittlere Gitterabstand G ist hierbei bevorzugt kleiner als eine kürzeste Wellenlänge einer Strahlung, die von der mindestens einen aktiven Schicht 5 im Betrieb des Dünnschichtbauelements 1 erzeugt wird. Hierdurch kann von den Oberteilen 7 und/oder von an der Halbleiterschichtenfolge 4 verbleibenden Unterteilen 12 ein photonischer Kristall gebildet sein, der zum Beispiel über Interferenz oder Beugung Strahlung bestimmter Wellenlängen nur in bestimmten Richtungen transmittiert.

Die Nanostäbe 3 können auf der Substratoberseite 10 über einen selbstorganisierten Prozess, über lithographische Methoden oder über ein Nano-Imprint-Verfahren aufgebracht werden. Bevorzugt erfolgt das Aufbringen der Nanostäbe 3 geordnet.

Die hier beschriebene Erfindung ist nicht durch die Beschreibung anhand der Ausführungsbeispiele beschränkt.

## Patentansprüche

1. Verfahren zur Herstellung eines Strahlung emittierenden Dünnschichtbauelements (1) mit den Schritten:
- Bereitstellen eines Substrats (2),
- Aufwachsen von Nanostäben (3) auf dem Substrat (2),
- epitaktisches Aufwachsen einer Halbleiterschichtenfolge (4) mit mindestens einer aktiven Schicht (5) auf den Nanostäben (3),
- Aufbringen eines Trägers (6) auf der Halbleiterschichtenfolge (4), und
- Abtrennen von Halbleiterschichtenfolge (4) und Träger (5) vom Substrat (2) durch mindestens teilweises Zerstören der Nanostäbe (3),
wobei
- die Nanostäbe (3) frei von einer aktiven Zone gewachsen werden,
- die Nanostäbe (3) und die Halbleiterschichtenfolge (4) aus unterschiedlichen Materialien gewachsen werden,
**dadurch gekennzeichnet, dass** die Nanostäbe (3) an einer dem Substrat (2) abgewandten Seite Oberteile (7) aufweisen und die Oberteile (7) eine geschlossene Schicht (9) bilden.

2. Verfahren nach Anspruch 1,
wobei das mindestens teilweise Zerstören der Nanostäbe (3) einen nass-chemischen Ätzprozess umfasst.

3. Verfahren nach Anspruch 1 oder 2,
wobei die vom Substrat (2) abgewandten Oberteile (7) der Nanostäbe (3) mit kegel- oder pyramidenartigen Spitzen (13) gestaltet werden, und
wobei die Nanostäbe (3) an Unterteilen (12), die dem Substrat (2) zugewandt sind, eine zylinderartige oder säulenartige Gestalt aufweisen und Übergänge zwischen den Oberteilen (7) und den Unterteilen (12) durch die Spitzen (13) der Oberteile (7) gebildet werden.

4. Verfahren nach einem der vorhergehenden Ansprüche, wobei die Nanostäbe (3) auf ZnO basieren oder aus ZnO bestehen.

5. Verfahren nach einem der vorhergehenden Ansprüche, wobei die Nanostäbe (3) in einem regelmäßigen Gitter angeordnet sind und ein mittlerer Gitterabstand (G) des Gitters höchstens 1000 nm beträgt.

6. Verfahren nach einem der vorhergehenden Ansprüche, wobei ein mittlerer Durchmesser (D) der Nanostäbe (3) höchstens eine halbe Wellenlänge einer von der mindestens einen aktiven Schicht (5) emittierten, höchstfrequenten Strahlung beträgt.

7. Verfahren nach einem der vorhergehenden Ansprüche, wobei eine Länge (L) der Nanostäbe (3) in einer Richtung senkrecht zu einer Substratoberseite (10) des Substrats (2) mindestens 500 nm beträgt.

8. Verfahren nach einem der vorhergehenden Ansprüche, bei dem der Schritt des Aufwachsens der Nanostäbe (3) das Ausbilden von Nukleationskeimen auf dem Substrat (2) umfasst, wobei die Nanostäbe (3), von den Nukleationskeimen ausgehend, in eine Richtung senkrecht zu einer Substratoberseite (10) weiterwachsen, und wobei die Nukleationskeime durch das Aufheizen einer Goldschicht gebildet werden.

9. Verfahren nach einem der vorhergehenden Ansprüche, wobei beim Abtrennen vom Substrat (2) die Oberteile (7) der Nanostäbe (3) mindestens teilweise an der Halbleiterschichtenfolge (4) verbleiben und die Nanostäbe (3) für eine Lichtauskoppelstruktur (14) des Dünnschichtbauelements (1) ausgebildet werden und das Dünnschichtbauelement (1) dazu eingerichtet ist, im grünen, blauen oder ultravioletten Spektralbereich Strahlung zu emittieren.

10. Verfahren nach einem der vorhergehenden Ansprüche, wobei die Nanostäbe (3) mit einem amorphen oder polykristallinen Material gestaltet werden.

11. Verfahren nach einem der vorhergehenden Ansprüche, wobei mit den Nanostäben (3) ein photonischer Kristall gebildet wird.

12. Verfahren nach einem der vorhergehenden Ansprüche, wobei die Halbleiterschichtenfolge (4) auf die geschlossene Schicht (9) gewachsen werden und das Wachsen der Halbleiterschichtenfolge (4) nach dem Wachsen der Nanostäbe (3) erfolgt, und
wobei das teilweise Entfernen der Nanostäbe (3) und das Entfernen von dem Substrat (2) erst nach dem Wachsen der Halbleiterschichtenfolge (4) mit der aktiven Schicht (5) erfolgt..

13. Verfahren nach einem der vorhergehenden Ansprüche, wobei das Substrat (2) mit Silizium gebildet ist,
- die Nanostäbe (3) selbstorganisiert aufgebracht werden,
- die Nanostäbe (3) auf ZnO und die Halbleiterschichtenfolge (4) auf GaN basieren,
- die Nanostäbe (3) eine Länge (L) im Bereich zwischen 500 nm und 1,5 µm und einen Durchmesser im Bereich zwischen 30 nm und 150 nm aufweisen,
- die Nanostäbe (3) frei von einer aktiven Zone sind,
- das Abtrennen vom Substrat (2) nass-chemisch erfolgt, und
- durch das Abtrennen das Substrat (2) nicht beschädigt wird.

14. Verfahren nach einem der vorhergehenden Ansprüche, wobei das Substrat (2) mit Saphir oder Silizium gebildet ist,
- die Nanostäbe (3) mit ZnO oder GaN gestaltet werden,
- die Nanostäbe (3) selbstorganisierend oder mit einem photolithographischen Schritt aufgebracht werden,
- die Halbleiterschichtenfolge (4) mit einer Dicke (T) von höchstens 100 µm aufgewachsen wird und auf GaN basiert,
- die Oberteile (7) der Nanostäbe (3) kegel- oder pyramidenförmig gewachsen werden, und wobei eine spitzenartige Struktur (13) der Oberteile (7) in Richtung zum Substrat (2) weist, und
- die Nanostäbe (3) nach dem Abtrennen vom Substrat (2) zum Teil an der Halbleiterschichtenfolge (4) verbleiben und eine Lichtauskoppelstruktur (14) bilden.

15. Strahlung emittierendes Dünnschichtbauelement (1) mit
- einem Träger (6),
- einer auf dem Träger (6) angebrachten und auf InGaN, AlGaN oder InAlGaN basierenden Halbleiterschichtenfolge (4) mit mindestens einer aktiven Schicht (5), die dazu gestaltet ist, elektromagnetische Strahlung zu emittieren, und
- einer Lichtauskoppelstruktur (14), die mit auf ZnO oder auf GaN basierenden Nanostäben (3) gebildet ist und sich an einer dem Träger (6) abgewandten Seite der Halbleiterschichtenfolge (4) befindet,
wobei die Nanostäbe (3) kegel- oder pyramidenartig gestaltet sind und durch die Nanostäbe (3) an einer Hauptseite (8) der Halbleiterschichtenfolge (4) eine geschlossene Schicht (9) gebildet ist,
**dadurch gekennzeichnet, dass** die geschlossene Schicht (9) als eine Wachstumsgrundlage für die Halbleiterschichtenfolge (4) eingesetzt ist.

## Claims

1. Method for producing a radiation-emitting thin-film component (1) comprising the following steps:
- providing a substrate (2),
- growing nanorods (3) on the substrate (2),
- epitaxially growing a semiconductor layer sequence (4) comprising at least one active layer (5) on the nanorods (3),
- applying a carrier (6) on the semiconductor layer sequence (4) and
- separating semiconductor layer sequence (4) and carrier (5) from the substrate (2) by at least partially destroying the nanorods (3),
wherein
- the nanorods (3) are grown in a manner free of an active zone,
- the nanorods (3) and the semiconductor layer sequence (4) are grown from different materials, **characterized in that** the nanorods (3) have upper parts (7) at a side facing away from the substrate (2), and the upper parts (7) form a closed layer (9).

2. Method according to Claim 1,
wherein at least partly destroying the nanorods (3) comprises a wet-chemical etching process.

3. Method according to Claim 1 or 2,
wherein the upper parts (7) of the nanorods (3) facing away from the substrate (2) are fashioned with cone- or pyramid-like tips (13), and
wherein the nanorods (3) have a cylinder-like or column-like shape at lower parts (12) facing the substrate (2), and transitions between the upper parts (7) and the lower parts (12) are formed by the tips (13) of the upper parts (7).

4. Method according to any of the preceding claims, wherein the nanorods (3) are based on ZnO or consist of ZnO.

5. Method according to any of the preceding claims, wherein the nanorods (3) are arranged in a regular lattice, and an average lattice spacing (G) of the lattice is at most 1000 nm.

6. Method according to any of the preceding claims, wherein an average diameter (D) of the nanorods (3) is at most half a wavelength of a highest-frequency radiation emitted by the at least one active layer (5).

7. Method according to any of the preceding claims, wherein a length (L) of the nanorods (3) in a direction perpendicular to a substrate top side (10) of the substrate (2) is at least 500 nm.

8. Method according to any of the preceding claims, wherein the step of growing the nanorods (3) comprises forming nucleation nuclei on the substrate (2), wherein the nanorods (3), proceeding from the nucleation nuclei, grow further in a direction perpendicular to a substrate top side (10), and wherein the nucleation nuclei are formed by the heating of a gold layer.

9. Method according to any of the preceding claims, wherein, during removal from the substrate (2), the upper parts (7) of the nanorods (3) remain at least partly at the semiconductor layer sequence (4) and the nanorods (3) are formed for a light coupling-out structure (14) of the thin-film component (1) and the thin-film component (1) is designed to emit radiation in the green, blue or ultraviolet spectral range.

10. Method according to any of the preceding claims, wherein the nanorods (3) are fashioned with an amorphous or polycrystalline material.

11. Method according to any of the preceding claims, wherein a photonic crystal is formed with the nanorods (3).

12. Method according to any of the preceding claims, wherein the semiconductor layer sequence (4) is grown onto the closed layer (9) and the growth of the semiconductor layer sequence (4) is carried out after the growth of the nanorods (3), and wherein the partial removal of the nanorods (3) and the removal from the substrate (2) are carried out only after the growth of the semiconductor layer sequence (4) with the active layer (5).

13. Method according to any of the preceding claims, wherein the substrate (2) is formed with silicon,
- the nanorods (3) are applied in a self-assembled manner,
- the nanorods (3) are based on ZnO and the semiconductor layer sequence (4) is based on GaN,
- the nanorods (3) have a length (L) in the range of between 500 nm and 1.5 µm and a diameter in the range of between 30 nm and 150 nm,
- the nanorods (3) are free of an active zone,
- the separation from the substrate (2) is carried out wet-chemically, and
- the substrate (2) is not damaged by the separation.

14. Method according to any of the preceding claims, wherein the substrate (2) is formed with sapphire or silicon,
- the nanorods (3) are fashioned with ZnO or GaN,
- the nanorods (3) are applied in a self-assembling manner or by means of a photolithographic step,
- the semiconductor layer sequence (4) is grown with a thickness (T) of at most 100 µm and is based on GaN,
- the upper parts (7) of the nanorods (3) are grown in conical or pyramidal fashion, and wherein a tip-like structure (13) of the upper parts (7) faces in the direction towards the substrate (2), and
- the nanorods (3), after separation from the substrate (2) remain in part at the semiconductor layer sequence (4) and form a light coupling-out structure (14).

15. Radiation-emitting thin-film component (1) comprising:
- a carrier (6),
- a semiconductor layer sequence (4) fitted on the carrier (6) and based on InGaN, AlGaN or InAlGaN and having at least one active layer (5) designed to emit electromagnetic radiation, and
- a light coupling-out structure (14), which is formed with nanorods (3) based on ZnO or on GaN and is situated at a side of the semiconductor layer sequence (4) facing away from the carrier (6),
wherein the nanorods (3) are fashioned in a cone- or pyramid-like manner and a closed layer (9) is formed by the nanorods (3) at a main side (8) of the semiconductor layer sequence (4), **characterized in that**
the closed layer (9) is used as a growth basis for the semiconductor layer sequence (4).

## Revendications

1. Procédé de fabrication d'un composant (1) en couche mince émettant un rayonnement, le procédé présentant les étapes qui consistent à :
prévoir un substrat (2),
faire croître des nano-barres (3) sur le substrat (2),
faire croître par épitaxie sur les nano-barres (3) une succession (4) de couches semi-conductrices comptant au moins une couche active (5),
appliquer un support (6) sur la succession (4) de couches semi-conductrices et
séparer la succession (4) de couches semi-conductrices et le support (5) du substrat (2) par destruction au moins partielle des nano-barres (3),
- les nano-barres (3) croissant en étant exemptes de zone active,
- les nano-barres (3) et la succession (4) de couches semi-conductrices croissant à partir de matériaux différents,
**caractérisé en ce que**
les nano-barres (3) présentent des parties supérieures (7) sur un côté non tourné vers le substrat (2) et
**en ce que** les parties supérieures (7) forment une couche (9) fermée.

2. Procédé selon la revendication 1, dans lequel la destruction au moins partielle des nano-barres (3) comporte une opération de gravure chimique par voie humide.

3. Procédé selon les revendications 1 ou 2, dans lequel les parties supérieures (7), non tournées vers le substrat (2), des nano-barres (3) sont configurées avec un sommet conique ou pyramidal (13) et en ce que les nano-barres (3) présentent sur des parties inférieures (12) tournées vers le substrat (2) une forme cylindrique ou en colonne, des transitions entre les parties supérieures (7) et les parties inférieures (12) étant formées par les sommets (13) des parties supérieures (7).

4. Procédé selon l'une des revendications précédentes, dans lequel les nano-barres (3) sont à base de ZnO ou constituées de ZnO.

5. Procédé selon l'une des revendications précédentes, en ce que les nano-barres (3) sont disposées en un réseau régulier, la distance moyenne (G) du réseau étant d'au plus 1 000 nm.

6. Procédé selon l'une des revendications précédentes, dans lequel le diamètre moyen (D) des nano-barres (3) correspond au plus à la moitié de la longueur d'onde du rayonnement à la fréquence la plus élevée émis par la ou les couches actives (5).

7. Procédé selon l'une des revendications précédentes, dans lequel la longueur (L) des nano-barres (3) dans une direction perpendiculaire à un côté supérieur (10) du substrat (2) est d'au moins 500 nm.

8. Procédé selon l'une des revendications précédentes, dans lequel l'étape de croissance des nano-barres (3) comporte la formation de germes de nucléation sur le substrat (2), les nano-barres (3) poursuivant, partant des germes de nucléation, leur croissance dans une direction perpendiculaire au côté supérieur (10) du substrat, les germes de nucléation étant formés par chauffage d'une couche d'or.

9. Procédé selon l'une des revendications précédentes, dans lequel lors de la séparation du substrat (2), les parties supérieures (7) des nano-barres (3) restent au moins en partie sur la succession (4) de couches semi-conductrices et les nano-barres (3) sont configurées pour une structure (14) d'émission de lumière du composant (1) en couche mince, le composant (1) en couche mince étant conçu pour émettre un rayonnement dans la plate spectrale du vert, du bleu ou de l'ultraviolet.

10. Procédé selon l'une des revendications précédentes, dans lequel les nano-barres (3) sont formées d'un matériau amorphe ou d'un matériau polycristallin.

11. Procédé selon l'une des revendications précédentes, dans lequel un cristal photonique est formé des nano-barres (3).

12. Procédé selon l'une des revendications précédentes, dans lequel la succession (4) de couches semi-conductrices croît sur la couche fermée (9) et la croissance de la succession (4) de couches semi-conductrices a lieu après la croissance des nano-barres (3), l'enlèvement partiel des nano-barres (3) et l'enlèvement du substrat (2) ne s'effectuant qu'après la croissance de la succession (4) de couches semi-conductrices avec la couche active (5).

13. Procédé selon l'une des revendications précédentes, dans lequel le substrat (2) est formé de silicium, les nano-barres (3) sont appliquées en une auto-organisation, les nano-barres (3) sont à base de ZnO et la succession (4) de couches semi-conductrices de GaN, les nano-barres (3) présentent une longueur (L) comprise entre 500 nm et 1,5 µm et ont un diamètre compris entre 30 nm et 150 nm, les nano-barres (3) ne présentent pas de zone active, la séparation du substrat (2) s'effectue par voie chimique humide et la séparation n'endommage pas le substrat (2).

14. Procédé selon l'une des revendications précédentes, dans lequel le substrat (2) est formé de saphir ou de silicium, les nano-barres (3) sont formées de ZnO ou de GaN, les nano-barres (3) sont appliquées de façon auto-organisée ou avec une étape photolithographique, la succession (4) de couches semi-conductrices croît à une épaisseur (T) d'au plus 100 µm et est à base de GaN, la partie supérieure (7) des nano-barres (3) croît en forme de cône ou de pyramide, une structure (13) en forme de sommet des parties supérieures (7) étant orientée en direction du substrat (2) et les nano-barres (3) restent et forment une structure (14) d'émission de lumière après la séparation du substrat (2) en partie sur la succession (4) de couches semi-conductrices.

15. Composant (1) en couche mince émettant un rayonnement, et présentant
un support (6),
une succession (4) de couches semi-conductrices appliquées sur le support (6) et à base d'InGaN, d'AlGaN ou d'InAlGaN, et présentant au moins une couche active (5) configurée pour émettre un rayonnement électromagnétique et
une structure (14) d'émission de lumière formée de nano-barres (3) à base de ZnO ou de GaN, qui se situe sur un côté de la succession (4) de couches semi-conductrices non tournées vers le support (6),
les nano-barres (3) ayant une forme de cône ou de pyramide et une couche fermée (9) est formée par les nano-barres (3) sur un côté principal (8) de la succession (4) de couches semi-conductrices, **caractérisé en ce que**
la couche fermée (9) est utilisée comme base de croissance pour la succession (4) de couches semi-conductrices.
